# EUROPEAN PATENT APPLICATION

(11) **EP 0 680 149 A2**
(43) Date of publication of application: **02.11.1995**
(21) Application number: 95301964.3
(22) Date of filing: 24.03.1995
(51) Int. Cl.: H03M 1/08

(54) **Analogue-to-digital conversion systems**

(30) Priority: 30.04.1994 GB 9408686
(71) Applicant: Smiths Industries Public Limited Company, London, NW11 8DS (GB)
(72) Inventor: Newman, Anthony Philip, Maidstone, Kent ME15 8EF (GB)
(74) Representative: Flint, Jonathan McNeill

(57) **Abstract**

An analogue-to-digital conversion system with multiple inputs 2 to 9 has a multiplexer 1 that provides sequential output samples of the inputs via an amplifier 19 to an analogue-to digital converter 20. A multiplier 18 between the multiplexer 1 and the amplifier 19 spectrally shifts the signals in one sense. A second multiplier 28 at the output of the converter 20 spectrally shifts the signals in the opposite sense to substantially their original spectral content. The second multiplier 28 also spectrally shifts any noise produced by the amplifier 19. A digital filter 30 attenuates the noise more than the signal and supplies the different outputs to respective registers 32 to 39. One of the inputs is at a zero level and the equivalent output is subtracted from the other outputs, further reducing noise.

## Description

This invention relates to analogue-to-digital conversion systems of the kind including a plurality of analogue signal inputs, a multiplexer that receives the signals from the inputs and provides sequential output samples of the analogue signals, an analogue-to-digital converter and an amplifier intermediate the multiplexer and the converter.

It is often necessary to convert several analogue signals from different sources into equivalent digital signals. This can be done by supplying the output of each analogue signal source to its own signal conditioning analogue-to-digital converter (ADC) so that each ADC produces a respective digital output. This, however, can require a large amount of processing circuitry to perform the conversion if there are a large number of sources. It can also lead to high power consumption. Alternatively, a system with signals from several sources can employ a single ADC, which is time shared or multiplexed between the different sources. Where the sources are of similar kinds, producing outputs of the same kind, this does not present any significant problems since all the signals can be amplified by the same amplifier after multiplexing and before being supplied to the ADC. However, in many cases the system needs to handle inputs from a variety of different kinds of sources, which may have outputs at very different frequencies and magnitudes. In such cases, it is necessary for the output from each source to be supplied to its own different signal conditioning circuit so that all the outputs are brought within a prescribed range of values that can be multiplexed and converted to digital values. The need to provide signal conditioning circuits for each source adds considerably to the complexity, size, cost and power consumption of the system.

It is an object of the present invention to provide an improved analogue-to-digital conversion system and method.

According to the present invention there is provided an analogue-to-digital conversion system of the above-specified kind, characterised in that the system includes a first device intermediate the multiplexer and the amplifier for spectrally shifting the signals supplied to the amplifier in a first sense, a second device connected to receive the output from the converter for spectrally shifting the signals in a second sense opposite from the first device so that the signals resume substantially their original spectral content and so that noise introduced between the first and second devices is spectrally shifted, and a digital filter connected to receive the output of the second device and to attenuate the noise to a greater extent than the signals.

The first and second devices for spectrally shifting the signals are preferably multipliers. The amplifier preferably has a programmable gain that can be different for each one of the signals. The system may include a separate store for each input, the different outputs from the filter being supplied to different ones of the stores. One of the inputs is preferably set at a zero level, the contents of the store associated with the zero level input being subtracted from the contents of each of the other stores.

An analogue-to-digital conversion system and method for an aircraft will now be described, by way of example, with reference to the accompanying drawings, in which:

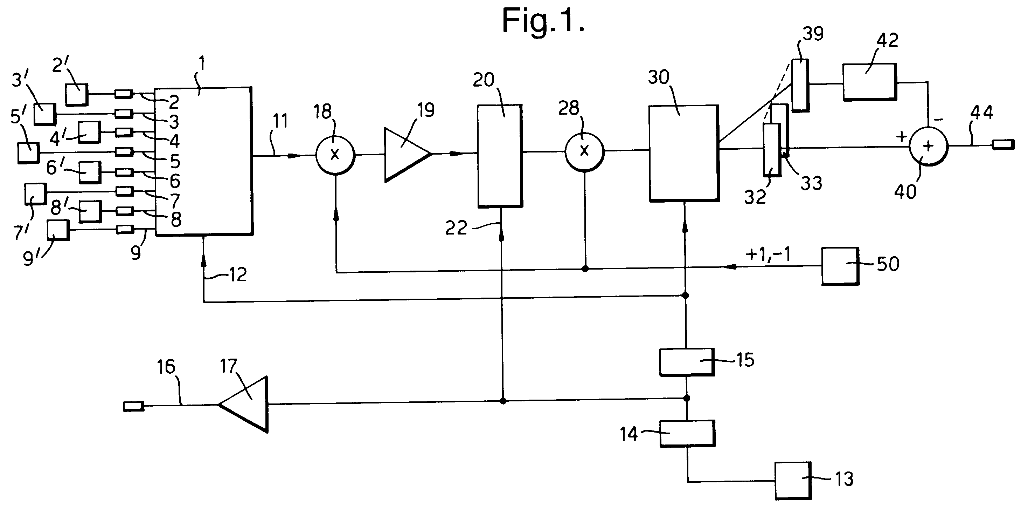

- Figure 1: shows the system schematically; and
- Figures 2 to 6: illustrate operation of the system

The system has a conventional analogue multiplexer 1 with eight input lines 2 to 9 supplied with signals direct from analogue sources 2' to 9' without any signal conditioning. The source 2' is a linear voltage displacement transducer producing alternating sinusoidal signals with a range in the order of -5 volts to + 5 volts RMS and a frequency of about 2KHz. The source 3' is a thermocouple producing a slowly varying dc voltage between about - 3mV and + 49mV. The source 4' is a three-wire platinum resistance thermometer producing a slowly varying dc voltage between about 340mV and 1040mV. The fourth source 5' is a voltage monitor producing a dc voltage between about - 5 volts and + 5 volts. The fifth, sixth and seventh sources 6', 7' and 8' produce various dc and ac signals. These seven input signals, therefore, vary considerably in magnitude and frequency. The signal on the final line 9 is a check input set at zero volts dc.

The multiplexer 1 produces a time-shared output signal on a single output line 11, which is a discrete sample of each one of the eight input signals in succession. The multiplexer 1 is driven by signals on line 12 derived from a clock source 13 via two, series-connected counters 14 and 15, which act as dividers. The frequency of the clock source 13, together with the counters 14 and 15, determine both the order in which the analogue signal sources are sampled and the individual sampling rates at the analogue signal sources. By an appropriate choice of counters 14 and 15, diverse sampling rate requirements can be accommodated within the common processing channel. The output signals from the first counter 14 are supplied to an output line 16, via an analogue low-pass filter 17, and provide a reference signal for the linear voltage displacement transducer 2'.

The analogue output signal samples from the multiplexer 1 on line 11 are supplied to the input of a multiplier 18. The purpose of the multiplier 18 will be explained in detail later but, briefly, it serves to introduce a spectral shift in the output signals from the multiplexer 1.

The system includes an amplifier 19 having a programmable gain, which receives at its input the spectrally shifted signals on line 11 produced by the multiplier 18. The output of the amplifier 19 is connected to the input of a conventional analogue-to-digital converter ADC 20. The ADC is a 12 bit bipolar device and the gain of the amplifier 19 is typically set, for each analogue signal source, such that the maximum input to the ADC is equivalent to 90% of the available dynamic range of the ADC. The ADC receives a clock signal on fine 22 from the first counter 14, resulting in a conversion rate of F samples per second.

The digital, time-shared output of the ADC 20 is connected to a second multiplier 28, which produces a spectral shift in the output in the opposite sense from that produced by the first multiplier 18. The output of the second multiplier 28 is connected to the input of a time-shared decimating digital filter 30. The filter 30 may be of the kind described in the following articles: "Digital signal processing schemes for efficient interpolation and decimation". by Valenzuela, R. A. and Constantinides, A. G., IEE Proc. Vol 130, Pt G, No 6. December 1983; and "High efficiency wave translation filters for sonar band selection" by Constantinides, A. G. and Curtis, T. E., Proc. Inst. Acoustics, Vol 11, Pt 8, 1989.

The output of the filter 30 is switched between eight different registers 32 to 39 or similar stores (only three of which are shown) in turn, under control of the output from the counter 15. Each register 32 to 39 corresponds to one of the eight different analogue input signals supplied to the system on lines 2 to 9. The outputs from seven of the registers 32 to 38 are connected to the positive input of an adder 40. The final register 39, corresponding to the check input on line 9, is connected via a moving average filter 42 to the negative input of the adder 40 so that its value is subtracted from the value supplied to the positive input. The output of the adder 40 is supplied on line 44 as the output of the system.

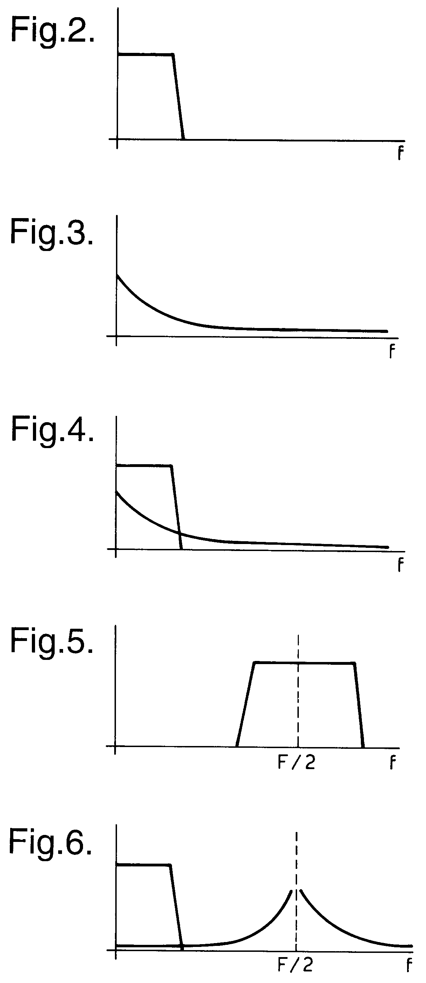

In operation, a signal from one of the sources 2' to 9', such as the resistance thermometer 4' might take the form shown in Figure 2, having a relatively narrow bandwidth of low frequency. Noise introduced by the amplifier 19 would typically have the form shown in Figure 3 and is of relatively high value at low frequency, reducing asymptotically with increasing frequency. Without the provisions of the present invention, the noise would be superimposed on the signal in the manner shown in Figure 4 and would result in inaccuracies and errors.

The multiplier 18 receives the output from the multiplexer 1 at one input and at its other input a multiplying factor from a unit 50 that alternates between + 1 and -1 on alternate samples of each analogue signal source. The result of this multiplication is to increase the frequency of the signal in the manner shown in Figure 5. Because the noise arises mainly in the amplifier 19, after the multiplier 18, it is not subject to this spectral shift. The spectrally-shifted signal and the noise are both converted into digital form in the converter 20. The resultant digital signal is then again multiplied by the factor + 1 or -1 from the unit 50, in the second multiplier 28. The result of this is that the noise is spectrally shifted to a higher frequency whereas the signal is shifted in the opposite direction, back to its original lower frequency, as shown in Figure 6. It can be seen that the result of this is that the amplitude of the noise occurring within the bandwidth of the signal has been considerably reduced. The digital filter 30 is controlled by the output of the counter 15 is that it processes, in turn, the appropriate signal samples corresponding to analogue signal source 2' to 9' and in such a way that it passes the signal presently being supplied to it but excludes noise outside the frequencies of the signal. With the signals shown in Figure 6, the filter 30 is set to be a low-pass filter that passes the signal and the noise below a certain frequency, but attenuates most other noise at higher frequencies.

The d.c. noise component of the output signal is further reduced by use of the check signal on line 9. The contents of the register 39 should be zero, representative of the zero volts input. Any noise present in the system and passed by the filter 30 will cause a digital value to appear in the register 39. This value will be a combination of d.c. and a.c. noise components. The moving average filter 42 averages the contents of the register 39 and supplies this to the negative input of the adder 40 so that it is subtracted from the contents of the other registers 32 to 38 before they are supplied to the output line 44.

It can be seen that the system of the present invention enables a considerable reduction in analogue signal conditioning but without noise problems of the kind that might be expected to arise from the amplification of unconditioned signals. Because of the reduction in analogue circuitry the system is considerably simpler and can be made at low cost and with lower power dissipation. Systems according to the present invention are able to process a wide range of different types of analogue signal sources within a single common time-shared or multiplexed processing channel. The output signals can also be relatively insensitive to the effects of change in ambient temperature, ageing of components and variations in the power supply. The entire system could be produced as an ASIC or by discrete units.

## Claims

1. An analogue-to-digital conversion system including a plurality of analogue signal inputs (2 to 9), a multiplexer (1) that receives the signals from the inputs and provides sequential output samples of the analogue signals, an analogue-to-digital converter (20) and an amplifier (19) intermediate the multiplexer (1) and the converter (20), characterised in that the system includes a first device (18) intermediate the multiplexer (1) and the amplifier (19) for spectrally shifting the signals supplied to the amplifier in a first sense, a second device (28) connected to receive the output from the converter (20) for spectrally shifting the signals in a second sense opposite from the first device (18) so that the signals resume substantially their original spectral content and so that noise introduced between the first and second devices (18 and 28) is spectrally shifted, and a digital filter (30) connected to receive the output of the second device (28) and to attenuate the noise to a greater extent than the signals.

2. An analogue-to-digital conversion system according to Claim 1, characterised in that the first and second devices for spectrally shifting the signals are multipliers (18 and 28).

3. An analogue-to-digital conversion system according to Claim 1 or 2, characterised in that the amplifier (19) has a programmable gain that can be different for each of the input signals.

4. An analogue-to-digital conversion system according to any one of the preceding claims, characterised in that the system includes a separate store (32 to 39) for each input, and that the different outputs from the filter (30) are supplied to different ones of the stores (32 to 39).

5. An analogue-to-digital conversion system according to Claim 4, characterised in that one of the inputs (9) is set at a zero level and that the contents of the store (39) associated with the zero level input are subtracted from the contents of each of the other stores (32 to 38).
